(19) Europäisches Patentamt
European Patent Office
Office européen des brevets

(11) Veröffentlichungsnummer: **0 028 749**
**B1**

(12) # EUROPÄISCHE PATENTSCHRIFT

(45) Veröffentlichungstag der Patentschrift: **07.08.85**

(51) Int. Cl.$^4$: **G 03 C 1/68,** C 08 F 2/50

(21) Anmeldenummer: **80106534.3**

(22) Anmeldetag: **24.10.80**

(54) **Photopolymerisierbares Gemisch und damit hergestelltes photopolymerisierbares Kopiermaterial.**

(30) Priorität: **07.11.79 DE 2944866**

(43) Veröffentlichungstag der Anmeldung:
**20.05.81 Patentblatt 81/20**

(45) Bekanntmachung des Hinweises auf die Patenterteilung:
**07.08.85 Patentblatt 85/32**

(84) Benannte Vertragsstaaten:
**AT BE CH DE FR GB LI SE**

(56) Entgegenhaltungen:
**DE-A-1 813 011**
**US-A-3 046 127**
**US-A-3 674 486**
**US-A-3 820 993**
**US-A-4 168 981**

**CHEMICAL REVIEWS, Band 68, Nr. 2, 25. März 1968, Seiten 125/151. American Chemical Society, Easton, US G. OSTER et al. "Photopolymerization of vinyl monomers"**

(73) Patentinhaber: **HOECHST AKTIENGESELLSCHAFT**
**Postfach 80 03 20**
**D-6230 Frankfurt am Main 80 (DE)**

(72) Erfinder: **Horn, Klaus, Dr.**
**Lessingstrasse 53**
**D-6238 Hofheim/Ts. (DE)**
Erfinder: **Klüpfel, Kurt, Dr.**
**Dreispitzstrasse 2a**
**D-6200 Wiesbaden-Sonnenberg (DE)**

**EP 0 028 749 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

**Beschreibung**

Die Erfindung betrifft ein photopolymerisierbares Gemisch, das ein gesättigtes polymeres Bindemittel, ein äthylenisch ungesättigte polymerisierbare Verbindung und einen Photoinitiator enthält, sowie ein Kopiermaterial zur Herstellung von Reliefbildern, insbesondere Druckformen und Photoresists, das aus einem Schichtträger und einer aus dem Gemisch bestehenden photopolymerisierbaren Schicht besteht.

Photopolymerisierbare Gemische und Materialien der angegebenen Gattung sind bekannt. Bei ihrer Verarbeitung ist es notwendig, den Einfluß des Luftsauerstoffs auf die radikalische Polymerisation während der Belichtung auszuschalten oder so weit wie möglich zu unterdrücken. Das erfolgt zumeist dadurch, daß man die photopolymerisierbare Schicht mit einem abziehbaren sauerstoffundurchlässigen Deckblatt (US—A—3 060 026) oder mit einer sauerstoffundurchlässigen Deckschicht abdeckt, die in dem Entwickler löslich ist (US—A—3 458 311). Hierdurch wird verhindert, daß während der lichtinduzierten Polymerisation Sauerstoff in die Schicht eindiffundiert und dort zu Kettenabbruchreaktionen führt, die sich in einer unvollständigen Polymerisation und damit geringeren Lichtempfindlichkeit auswirken. Durch die Sauerstoffhemmung geht insbesondere der Zusammenhang zwischen eingestrahlter Lichtmenge und Belichtungswirkung, z.B. dem Grad der Lichthärtung — die Reziprozität des Kopiermaterials — verloren.

Der Nachteil der zuerst genannten bekannten Materialien liegt in dem zusätzlichen Arbeitsschritt, der für das Aufbringen von Deckfolie oder Deckschicht erforderlich ist. Weiterhin wird die Bildauflösung bei Verwendung selbsttragender Deckfolien, die in der Regel eine Dicke um 20 µm haben, beim Kontaktkopieren verschlechtert. Deckschichten, die im Entwickler löslich sind, haben einen rascheren Verbrauch desselben und eine zusätzliche Abwasserbelastung zur Folge. Man hat deshalb versucht, photopolymerisierbare Materialien herzustellen, die auch ohne Deckschicht eine ausreichende Lichtempfindlichkeit bei der bildmäßigen Polymerisation zeigen.

In der DE—A—28 30 143 wird ein derartiges Material beschrieben, das bestimmte polymerisierbare Verbindungen mit höherem Molekulargewicht und bestimmte Initiatorsysteme enthält und daher eine geringere Sauerstoffempfindlichkeit aufweist.

Aus der GB—A—1 110 050 ist ein photopolymerisierbares Gemisch bekannt, das relativ hochmolekulare polymerisierbare Verbindungen enthält und dadurch weniger empfindlich gegenüber Sauerstoff ist.

Schließlich wird in der DE—B—21 03 996 ein durch Bestrahlung polymerisierbares Gemisch beschrieben, das durch seinen Gehalt an einem bestimmten Bindemittel weniger sauerstoffempfindlich sein soll.

In der DE—A—29 26 235 ist vorgeschlagen worden, die Auswirkung der Polymerisationshemmung durch Sauerstoff dadurch gleichmäßiger zu gestalten, daß man eine photopolymerisierbare Schicht verwendet, die Pigmentteilchen einer bestimmten Größe enthält.

Aus den US—A—2 460 105 und 3 674 486 ist schließlich die Verwendung von bestimmten Dialkyldisulfiden als Photoinitiatoren in photopolymerisierbaren Gemischen bekannt. Eine geringere Sauerstoffempfindlichkeit dieser Gemische ist nicht angegeben. Die Initiatorwirkung dieser Verbindungen ist relativ niedrig.

In der DE—A—1 813 011 ist ein flüssiges photopolymerisierbares Gemisch für die Herstellung von Formkörpern und Überzügen beschrieben, das Monomere, ungesättigte Polyester, organische Disulfide und Sensibilisatoren enthält. Das Gemisch wird zum Schutz gegen Sauerstoff mit einer Paraffinhaut überdeckt und eignet sich nicht für die Herstellung lagerfähiger Reproduktionsmaterialien, da es flüssig ist.

Von den genannten Möglichkeiten zur Verminderung der Sauerstoffempfindlichkeit haben sich in der Praxis nur die Verwendung von undurchlässigen entwicklerlöslichen Deckschichten, insbesondere bei Flachdruckplatten, und von undurchlässigen abziehbaren Deckfolien, insbesondere bei Photoresist- und Bildübertragungsmaterialien, durchgesetzt. Die Gemische, die hochmolekulare Verbindungen mit seitenständigen äthylenisch ungesättigten, radikalisch polymerisierbaren Gruppen enthalten, haben keinen Eingang in die Praxis gefunden, es werden bisher allgemein niedermolekulare polymerisierbare Verbindung bevorzugt.

Aufgabe der Erfindung war es, ein photopolymerisierbares Gemisch vorzuschlagen, das gegen Sauerstoff wenig empfindlich ist, ohne daß es einer Schutzschicht oder Schutzfolie gegenüber dem Sauerstoff bedarf und dessen Zusammensetzung im Hinblick auf die Natur des Bindemittels, der polymerisierbaren Verbindung und des wirksamen Initiatorsystems keinen durch diese Aufgabe bedingten Beschränkungen unterworfen ist.

Die Erfindung geht aus von einem photopolymerisierbaren Gemisch, das ein gesättigtes polymeres Bindemittel, eine radikalisch polymerisierbare Verbindung mit mindestens zwei äthylenisch ungesättigten polymerisierbaren Gruppen und einen Photoinitiator in ausreichender Menge enthält, um die photoinitiierte radikalische Additionspolymerisation der polymerisierbaren Verbindung einzuleiten.

Das erfindungsgemäße Gemisch ist dadurch gekennzeichnet, daß es zusätzlich eine Verbindung der Formel

$$R_1—CH_2—S—S—CH_2—R_2$$

enthält, worin

$R_1$ und $R_2$ gleich oder verschieden sind und Alkyl-, Cycloalkyl-, Aryl-, Aralkyl- oder N-substituierte Carbamoyl- oder Carbamoylalkylreste bedeuten.

Disulfide der angegebenen Formel, in denen $R_1=R_2$ ist, werden im allgemeinen bevorzugt, da sie sich am einfachsten herstellen lassen.

Wenn $R_1$ und $R_2$ Alkylreste sind, haben sie im allgemeinen 1 bis 20, vorzugsweise 4 bis 15 Kohlenstoffatome. Cycloalkylreste können 3 bis 20, vorzugsweise 6 bis 15, und Arylreste 6 bis 20 Kohlenstoffatome haben. Die Reste können weitere Substituenten, wie Halogenatome, niedere Alkyl- und Alkoxygruppen mit 1 bis 4 Kohlenstoffatomen, Acylgruppen mit 2 bis 7 und primäre, sekundäre und tertiäre Aminogruppen, enthalten.

Die Disulfide werden dem Gemisch im allgemeinen in einer Menge von 0,1 bis 10, vorzugsweise 3 bis 8 Gew.-%, bezogen auf die nichtflüchtigen Bestandteile, zugesetzt. Der Gehalt an Disulfid ist häufig höher als der an Photoinitiatoren. Dennoch zeigt sich, daß die Disulfide jedenfalls bei Verwendung der unten angegebenen bevorzugten hochaktiven Initiatoren nur eine geringe oder gar keine Steigerung der Lichtempfindlichkeit bewirken, selbst wenn ihre Menge ein Mehrfaches der Initiatormenge beträgt.

Ein wesentlicher Unterschied in der Lichtempfindlichkeit wird jedoch in Gegenwart von Sauerstoff beobachtet, d.h. mit photopolymerisierbaren Schichten, deren Oberfläche der Atmosphäre ausgesetzt und nicht durch eine sauerstoffundurchlässige Deckschicht oder Deckfolie abgedeckt ist. Im Idealfall wird hier eine vollständige Reziprozität erreicht, d.h. eine bildmäßige Photopolymerisation, die der eingestrahlten Lichtmenge, dem Produkt aus Beleuchtungsstärke und Belichtungszeit, proportional ist. In jedem Fall wird aber eine wesentliche Verminderung der Polymerisationshemmung durch Sauerstoff erreicht, die sich dadurch zu erkennen gibt, daß das Ausmaß der Lichthärtung über einen weiten Bereich mit der Lichtmenge ansteigt.

Ein weiterer Vorteil des erfindungsgemäßen Gemischs ist seine geringe Neigung zur thermischen Polymerisation im Dunklen, also seine erhöhte Lagerfähigkeit.

Das erfindungsgemäße Gemisch kann gewerblich in Form einer Lösung oder Dispersion, z.B. als sogenannter Kopierlack, verwertet werden, die vom Verbraucher selbst auf einen individuellen Träger, z.B. zum Formteilätzen, für die Herstellung kopierter Schaltungen, von Schablonen, Beschilderungen, Siebdruckformen und dgl., aufgebracht und nach dem Trocknen belichtet und zur bildmäßig verteilten Schicht entwickelt werden.

Das Gemisch kann insbesondere auch in Form einer festen, auf einem Träger befindlichen photopolymerisierbaren Schicht als lichtempfindliches Kopiermaterial für die Herstellung von Druckformen, Reliefbildern, Ätzreserven, Schablonen, Matern, Siebdruckformen, Farbprüffolien, Einzelkopien und dgl. in den Handel gebracht werden. Eine wichtige Anwendung ist vor allem die Herstellung lagerfähig vorsensibilisierter Druckplatten für den Hoch-, Tief- und insbesondere dan Flachdruck.

Wenn das Gemisch in flüssiger Form als sogenannter Kopierlack aufbewahrt und erst unmittelbar vor der Anwendung auf die Unterlage, z.B. einen Siebdruckträger, eine kupferkaschiertes Basismaterial zur Herstellung von Leiterplatten oder dgl., aufgebracht werden soll, werden die Schichtbestandteile in einem geeigneten Lösungsmittel bzw. Lösungsmittelgemisch gelöst oder dispergiert. Als Lösungsmittel sind Alkohole, Ketone, Ester, Äther, Amide, Kohlenwasserstoffe und dgl. geeignet. Vor allem werden die Partialäther mehrwertiger Alkohole, insbesondere der Glykole, verwendet.

Die Lösungen bzw. Dispersionen können für die Herstellung von Druckplatten usw. mit Vorteil unmittelbar nach ihrer Herstellung auf einen geeigneten Träger aufgebracht und als lichtempfindliche Kopiermaterialien aufbewahrt und in den Handel gebracht werden. Hierbei können die gleichen oder ähnliche Lösungsmittel wie für die Herstellung der Kopierlacke verwendet werden. Der Antrag erfolgt, z.B. durch Gießen, Sprühen, Eintauchen etc.

Als Schichtträger eignen sich z.B. Zink, Kupfer, Aluminium, Stahl, Polyester- bzw. Acetatfolie, Perlongaze etc., deren Oberfläche bei Bedarf einer Vorbehandlung unterworfen sein kann.

Erforderlichenfalls wird zwischen Träger und lichtempfindlicher Schicht eine haftvermittelnde Zwischenschicht bzw. eine Lichthofschutzschicht aufgebracht.

Das erfindungsgemäße Gemisch besteht im wesentlichen aus Monomeren, Photoinitiatoren, Bindemitteln und den beschriebenen Disulfiden; sie kann jedoch noch eine Reihe weiterer Zusätze enthalten, z.B.

Stabilisatoren bzw. Inhibitoren zur Verhinderung der thermischen Polymerisation der Kopierschicht, Wasserstoffdonatoren, Weichmacher, sensitometrische Regler und Farbstoffe oder Farbpigmente.

Als Photoinitiatoren eignen sich eine Vielzahl von Substanzen, beispielsweise Benzoin, Benzoinäther, Mehrkernchinone, z.B. 2-Äthyl-anthrachinon; Acridinderivate, z.B. 9-Phenyl-acridin, 9-p-Methoxyphenylacridin, 9-Acetylamino-acridin, Benz(a)acridin; Phenazinderivate, z.B. 9,10-Dimethyl-benz(a)phenazin, 9-Methyl-benz(a)-phenazin, 10-Methoxy-benz(a)phenazin; Chinoxalinderivate, z.B. 6,4',4''-Trimethoxy-2,3-diphenyl-chinoxalin, 4',4''-Dimethoxy-2,3-diphenyl-5-aza-chinoxalin; Chinazolinderivate; synergistische Mischungen verschiedener Ketone; Farbstoff/Redox-systeme; Thiopyryliumsalze und dgl. mehr.

Besonders gut geeignet sind die in der DE—C—20 47 467 beschriebenen Acridin- und Phenazinverbindungen, die in der DE—C—20 39 861 beschriebenen Chinoxalin- und Chinazolinverbindungen und die in der DE—A—28 50 585 beschriebenen Benzalchinaldinverbindungen. Die Initiatoren werden im allgemeinen in einer Menge von 0,01 bis 10, bevorzugt 0,2 bis 5 Gew.-%, bezogen auf die nichtflüchtigen Bestandteile des Gemischs, zugesetzt.

Für die Zwecke der Erfindung geeignete photopolymerisierbare Monomere sind bekannt und z.B. in den USA—Patentschriften 2 760 863 und 3 060 023 beschrieben.

Bevorzugte Beispiele sind Acryl- und Methacrylsäureester von mehrwertigen Alkoholen, wie Diglycerindiacrylat, Polyäthylenglykoldimethacrylat, Acrylate und Methacrylate von Trimethyloläthan, Trimethylolpropan und Pentaerythrit und von mehrwertigen alicyclischen Alkoholen. Niedermolekulare Ester mit Molekulargewichten unterhalb 1000, insbesondere unterhalb 500, werden allgemein bevorzugt. Mit Vorteil werden für bestimmte Zwecke auch Umsetzungsprodukte von Diisocyanaten mit Partialestern mehrwertiger Alkohole eingesetzt. Derartige Monomere sind in den DE—A—20 64 079 und DE—A—23 61 041 beschrieben.

Die Menge der Monomeren kann je nach ihrer Natur und ihrem Molekulargewicht sehr unterschliedlich sein. Im allgemeinen kann sie zwischen etwa 10 und 80, vorzugsweise zwischen 20 und 60 Gew.-%, betragen.

Als Wasserstoffdonatoren werden in der Hauptsache aliphatische Polyäther verwendet. Gegebenenfalls kann diese Funktion auch vom Bindemittel oder von dem polymerisierbaren Monomeren übernommen werden, wenn diese labile Wasserstoffatome besitzen.

Als Bindemittel können eine Vielzahl löslicher organischer, gesättigter Polymerisate Einsatz finden. Als Beispiele seien genannt: Polyamide, Polyvinylester, Polyvinylacetale, Polyvinyläther, Polyacrylsäureester, Polymethacrylsäureester, Polyester, Alkydharze, Polyacrylamid, Polyvinylalkohol, Polyäthylenoxid, Polydimethylacrylamid, Polyvinylpyrrolidon, Polyvinylmethylformamid, Polyvinylmethylacetamid sowie Mischpolymerisate der Monomeren, die die aufgezählten Homopolymerisate bilden.

Ferner kommen als Bindemittel Naturstoffe oder umgewandelte Naturstoffe in Betracht, z.B. Gelatine, Celluloseäther und dgl.

Mit besonderem Vorteil werden Bindemittel verwendet, die wasserunlöslich, aber in wäßrig-alkalischen Lösungen löslich oder mindestens quellbar sind, da sich Schichten mit solchen Bindemitteln mit den bevorzugten wäßrig-alkalischen Entwicklern entwickeln lassen. Derartige Bindemittel können z.B. die folgenden Gruppen enthalten: $—COOH$, $—PO_3H_2$, $—SO_3H$, $—SO_2NH_2$, $—SO_2—NH—CO—$ und dgl. Als Beispiele hierfür seien genannt: Maleinatharze, Polymerisate aus N - (p - Tolyl - sulfonyl) - carbaminsäure - (β - methacryloyloxy - äthyl)ester und Mischpolymerisate dieser und ähnlicher Monomerer mit anderen Monomeren, und Styrol - Maleinsäureanhydrid - Mischpolymerisate. Methylmethacrylat - Methacrylsäure - Mischpolymerisate und Mischpolymerisate aus Methacrylsäure, Alkylmethacrylaten und Methylmethacrylat und/oder Styrol, Acrylnitril u.a., wie sie in den DE—B—20 64 080 und 23 63 806 beschrieben sind, werden bevorzugt.

Die Menge des Bindemittels beträgt im allgemeinen 20 bis 90, vorzugsweise 40 bis 80 Gew.-% der nichtflüchtigen Bestandteile des Gemischs.

Wenn das Gemisch zur Herstellung einer Druckplatte, z.B. einer Offsetdruckplatte, verwendet werden soll, wird es in Form einer Lösung auf einen Schichtträger aufgebracht und getrocknet. Die Auswahl der geeigneten Träger erfolgt nach Maßgabe der Art der Druckplatte. Im allgemeinen wird Aluminium verwendet, das bevorzugt eine anodisch erzeugte poröse Oxidschicht trägt. Das Aluminium wird zweckmäßig vor dem Anodisieren mechanisch, chemisch oder elektrolytisch aufgerauht. Die Anodisierung erfolgt in bekannter Weise, z.B. in Schwefel- und/oder Phosphorsäure, vorzugsweise unter solchen Bedingungen, daß eine Oxidschicht mit einem Schichtgewicht von etwa 0,5 bis 10 $g/m^2$ erhalten wird.

Vorteilhaft wird die Oxidschicht vor dem Aufbringen der lichtempfindlichen Schicht einer Vorbehandlung zur Verbesserung des drucktechnischen Verhaltens, insbesondere der Hydrophilie, unterworfen, z.B. mit Silikaten oder Polyvinylphosphonsäure. Die Beschichtung des Trägermaterials erfolgt in bekannter Weise durch Aufschleudern, Sprühen, Tauchen, mittels Walzen, Schlitzdüsen, Rakeln oder durch Gießer-Antrag.

Es ist vorteilhaft, der Streichlösung zwecks besserer Benetzung gegebenenfalls Netz- oder Verlaufmittel zuzusetzen.

Zur Entwicklung wird die belichtete Druckplatte mit einer geeigneten Entwicklerlösung, bevorzugt einer schwach alkalischen wäßrigen Lösung behandelt, wobei die unbelichteten Anteile der Schicht entfernt werden und die belichteten Bereiche der Kopierschicht einschließlich der in der Schicht enthaltenen Pigmente auf dem Träger zurückbleiben.

Der überwiegende Teil der oben genannten Disulfide ist aus der Literatur bekannt. Disulfide der allgemeinen Formel $R_1—CH_2—S—S—CH_2—R_2$, wobei $R_1=R_2$ ist, sind z.B. durch Oxydation der entsprechenden Mercaptane mit $FeCl_3$ oder Jod leicht herstellbar. Unsymmetrische Disulfide können z.B. durch Umsetzen von Sulfenylchloriden mit Mercaptanen hergestellt werden.

In der folgenden Tabelle sind einige Verbindungen zusammengestellt, deren Wirksamkeit in erfindungsgemäßen Gemischen erprobt wurde.

TABELLE
Verbindungen der Formel $R_1—CH_2—S—S—CH_2—R_2$

| Verbindungs-Nr. | Schmp. °C | Substituenten $R_1=R_2$ |
|---|---|---|
| 1 | flüssig | Heptyl- |
| 2 | 33 | Decyl- |
| 3 | 75 | Phenyl- |
| 4 | 157 | N-Phenyl-carbamoyl- |
| 5 | 164 | N-Phenyl-carbamoyl-methyl- |
| 6 | 173 | 4-Fluor-N-phenyl-carbamoyl-methyl- |
| 7 | 174 | 3,4-Dimethyl-N-phenyl-carbamoyl-methyl- |
| 8 | 162 | 2,4-Dichlor-N-phenyl-carbamoyl-methyl- |

Die Erfindung wird an Hand der nachfolgenden Beispiele näher erläutert, in denen Gewichtsteile (Gt) und Volumteile (Vt) im Verhältnis von g zu ccm stehen. Prozente sind, wenn nichts anderes angegeben ist, Gewichtsprozente.

Beispiel 1

a) Als Schichtträger für Druckplatten wird elektrochemisch aufgerauhtes und anodisiertes Aluminium mit einer Oxidschicht von 3 g/m$^2$ verwendet, das mit einer Lösung folgender Zusammensetzung überzogen wird:

11,7 Gt einer 33,4%igen Lösung eines Methylmethacrylat/Methacrylsäure-Mischpolymerisats mit der Säurezahl 110 und dem mittleren Mol-Gewicht 35.000 in Methyläthylketon,
3,9 Gt Trimethyloläthantriacrylat,
0,07 Gt 9-Phenyl-acridin,
0,07 Gt 4-Dimethylamino-4'-methyl-dibenzalaceton,
0,04 Gt eines Azofarbstoffs aus 2,4-Dinitro-6-chlor-benzoldiazoniumsalz und 2-Methoxy-5-acetylamino-N-cyanäthyl-N-hydroxyäthylanilin,
38,0 Gt Äthylenglykolmonoäthyläther,
13,5 Gt Butylacetat.

Das Auftragen erfolgt durch Aufschleudern in der Weise, daß ein Trockengewicht von 2,8—3 g/m$^2$ erhalten wird. Anschließend wird die Platte 2 Minuten bei 100°C im Umlufttrockenschrank getrocknet.

b) Eine weitere Platte wird hergestellt wie unter a) beschrieben und danach mit einer 15%igen wäßrigen Lösung von Polyvinylalkohol (12% Restacetylgruppen, K-Wert 4) beschichtet. Nach dem Trocknen wird eine Deckschicht mit einem Gewicht von 4—5 g/m$^2$ erhalten.

c) Eine weitere Platte aus dem gleichen Material wird mit der unter a) beschriebenen Lösung unter Zusatz von 0,6 Gt der Verbindung 5 beschichtet und getrocknet.

d) Eine vierte Platte wird wie unter c) beschrieben hergestellt und dann mit der unter b) beschriebenen Polyvinylalkohol-Deckschicht versehen.

Die 4 erhaltenen Druckplatten werden mittels einer 5 kW-Metallhalogenidlampe unter einem 13stufigen Belichtungskeil mit Dichteinkrementen von 0,15 jeweils 10, 20, 40 und 80 Sekunden belichtet.

Anschließend werden die Platten mit einem Entwickler folgender Zusammensetzung entwickelt:

120 Gt Natriummetasilikat · 9 $H_2O$,
2,13 Gt Strontiumchlorid,
1,2 Gt nichtionogenes Netzmittel (Kokosfettalkohol-Polyoxyäthylenäther mit ca. 8 Oxyäthyleneinheiten),
0,12 Gt Antischaummittel,
4000 Gt vollentsalztes Wasser.

Die Platten werden mit 1%iger Phosphorsäure sauer gestellt und mit fetter Druckfarbe eingefärbt. Man erhält die folgenden vollvernetzten Keilstufen:

| Platte | Deckschicht | Verbindung 5 | Belichtungszeit (Sekunden) 10 | 20 | 40 | 80 |
|---|---|---|---|---|---|---|
| a | ohne | ohne | — | 1 | 2 | 2 |
| b | mit | ohne | 1 | 3 | 5 | 7 |
| c | ohne | mit | 1 | 3 | 5 | 7 |
| d | mit | mit | 1 | 3 | 5 | 7 |

Bei Zusatz der Disulfidverbindung 5 wird das gleiche Kopiergebnis wie bei Anwendung einer die Diffusion des Sauerstoffs hemmenden Deckschicht erzielt. Aus dem Vergleich der Ergebnisse von b) und d) ergibt sich, daß die Verbindung 5 keine zusätzliche Initiatorwirkung hat, obwohl ihre Menge ein Mehrfaches der Menge von Phenylacridin und 4-Dimethylamino-4-methyl-dibenzalaceton beträgt.

Beispiel 2

Auf eine elektrochemisch aufgerauhte und anodisierte Aluminiumoberfläche mit einer Oxidschicht von 3 g/m² wird eine Lösung folgender Zusammensetzung so aufgeschleudert, daß ein Schichtgewicht von 3,5 g/m² erhalten wird:

10,0 Gt einer 20%igen Lösung eines Terpolymerisates aus Styrol, n-Hexylmethacrylat und Methacrylsäure (10:60:30) mit der Säurezahl 190 in Butanon,
2,0 Gt des Umsetzungsproduktes aus 1 Mol 2,2,4-Trimethyl-hexamethylendiisocyanat und 2 Mol 2-Hydroxy-äthylmethacrylat,
0,3 Gt 9-Phenyl-acridin,
0,15 Gt 4-Chlor-benzalchinaldin,
0,03 Gt Methylviolett (C.I. 42 535),
0,3 Gt Verbindung Nr. 6,
18.0 Gt Butanon,
7,5 Gt Butylacetat.

Die beschichtete Platte wird anschließend 2 Minuten bei 100°C im Umlufttrockenschrank getrocknet.

Eine weitere Platte wird in gleicher Weise, aber ohne Zusatz von Verbindung 6 hergestellt.

Man belichtet nun Proben jeder Platte 5, 10, 20 und 40 Sekunden unter einem 13stufigen Belichtungskeil und entwickelt mit einem Entwickler folgender Zusammensetzung:

5,3 Gt Natrium-metasilikat · 9 $H_2O$,
3,4 Gt tert. Natriumphosphat · 12 $H_2O$,
0,3 Gt sec. Natriumphosphat · 12 $H_2O$,
91,0 Gt vollentsalztes Wasser.

Die Platten werden mit 1%iger Phosphorsäure sauer gestellt und mit fetter Druckfarbe eingefärbt. Es werden die in der folgenden Tabelle angegebenen vollvernetzten Keilstufen erhalten:

| Verbindung 6 | Belichtungszeit (Sekunden) 5 | 10 | 20 | 40 |
|---|---|---|---|---|
| mit | 2 | 3 | 4 | 5 |
| ohne | 2 | 3 | 3 | 3 |

Die Platte arbeitet nicht streng reziprok. Die Zahl der Keilstufen nimmt jedoch linear mit der Belichtungszeit zu.

Beispiel 3

a) Auf eine elektrochemisch aufgerhaute, anodisierte Aluminiumoberfläche mit einer Oxidschicht von 3 g/m² wird eine Lösung folgender Zusammensetzung so aufgeschleudert, daß ein Schichtgewicht von 3 g/m² erhalten wird:

1,4 Gt der in Beispiel 1 angegebenen Mischpolymerisatlösung,
37,9 Gt Äthylenglykolmonoäthyläther,

13,45 Gt Butylacetat,
4,0 Gt Trimethyloläthantriacrylat,
0,07 Gt 4-Methyl-benzalchinaldin,
0,08 Gt des in Beispiel 1 angegebenen Azofarbstoffs,
0,07 Gt 4-Dimethylamino-4'-methyl-dibenzalaceton,
0,56 Gt Verbindung 2

Die beschichtete Platte wird 2 Minuten im Trockenschrank bei 100°C getrocknet.

b) Eine weitere Platte wird in gleicher Weise hergestellt und mit einer Deckschicht von 4—5 g/m² Polyvinylalkohol wie in Beispiel 1 versehen.

c) Eine dritte Platte wird wie unter a), jedoch ohne Zusatz der Verbindung 2, hergestellt.

d) Eine vierte Platte wird wie unter c) hergestellt und mit einer Deckschicht gemäß b) versehen.

Proben der erhaltenen Offsetdruckplatten werden mittels einer Metallhalogenidlampe von 5 kW 10, 20 und 40 Sekunden unter einem 13stufigen Belichtungskeil mit Dichteinkrementen von 0,15 belichtet.

Anschließend werden die Platten mit dem in Beispiel 1 beschriebenen Entwickler entwickelt.

Sie werden dann mit 1%iger Phosphorsäure sauer gestellt und mit fetter Druckfarbe eingefärbt. Man erhält die folgende Anzahl vollvernetzter Keilstufen:

| | | | Belichtungszeit (Sekunden) | | |
|---|---|---|---|---|---|
| Platte | Deckschicht | Verbindung 2 | 10 | 20 | 40 |
| a | ohne | mit | — | 1 | 3 |
| b | mit | mit | — | 1 | 3 |
| c | ohne | ohne | — | — | 2 |
| d | mit | ohne | — | 1 | 3 |

Beispiel 4

Aluminiumplatten von 0,3 mm Stärke, elektrochemisch aufgerauht und anodisiert (Oxidschicht 3 g/m²) werden mit einer Lösung folgender Zusammensetzung so beschichtet, daß nach dem Trocknen ein Schichtgewicht von 2,9 g/m² erhalten wird:

40 Gt Trimethyloläthantriacrylat,
30 Gt eines Terpolymerisats aus Styrol, n-Hexylmethacrylat und Methacrylsäure (10:60:30) mit der Säurezahl 180,
2,3 Gt 1-(2-Chinolyl)-2-(2-Fluorenyl)-äthylen,
0,8 Gt des in Beispiel 1 angegebenen Farbstoffs,
0,7 Gt 4-Dimethylamino-4'-methyl-dibenzalaceton,
5,8 Gt Verbindung Nr. 3,
360 Gt Methyläthylketon,
150 Gt Butylacetat.

Wie in Beispiel 3 werden 4 Platten hergestellt, belichtet und mit dem in Beispiel 1 angegebenen Entwickler entwickelt.

Nach dem Einfärben mit fetter Druckfarbe werden die folgenden vollvernetzten Glanzstufen erhalten:

| | | | Belichtungszeit (Sekunden) | | | |
|---|---|---|---|---|---|---|
| Platte | Deckschicht | Verbindung 3 | 10 | 20 | 40 | 80 |
| a | ohne | mit | — | 1 | 3 | 5 |
| b | mit | mit | 1 | 2 | 3 | 5 |
| c | ohne | ohne | — | — | 1 | 3 |
| d | mit | ohne | — | 1 | 2 | 4 |

Beispiel 5

Eine Lösung, wie in Beispiel 2 beschrieben, wird auf einen gereinigten Träger, der aus einem Isolierstoffmaterial mit 35 µm Kupferauflage besteht, so aufgeschleudert, daß man eine Schichtdicke von ca. 5 µm erhält. Die Schicht wird 5 Minuten bei 100°C im Umlufttrockenschrank nachgetrocknet. Der Beschichtungs- und Trocknungsvorgang kann auch beidseitig durchgeführt werden.

Anschließend werden Proben des Materials mittels einer 5 kW MH-Lampe mit 140 cm Abstand unter einem Stufenkeil, wie in Beispiel 1 beschrieben, 2, 4, 8, 16, 32 und 64 Sekunden belichtet und die Platten mit 0,8%iger Sodalösung in einem Sprühgerät 30 bis 60 Sekunden entwickelt.

Man erhält, entsprechend der Belichtungszeit, folgende vollvernetzte Keilstufen. In Klammern ist gegebenenfalls die Anzahl einschließlich der nahezu vollständig vernetzten Stufen angegeben.

| Belichtungszeit | Vollvernetzte Keilstufen |
|---|---|
| 2 Sekunden | 3 |
| 4 Sekunden | 4 |
| 8 Sekunden | 5 (6) |
| 16 Sekunden | 7 (8) |
| 32 Sekunden | 9 |
| 64 Sekunden | 10 (11) |

Wird die vernetzbare Schicht unter einer Schaltvorlage belichtet und entwickelt, so sind die vernetzten Bereiche gegen die in der Leiterplattentechnik übliche Eisen-III-chlorid-Ätzlösung resistent. Die Ätzfestigkeit ist gut.

**Patentansprüche**

1. Photopolymerisierbares Gemisch, das ein gesättigtes polymeres Bindemittel, eine radikalisch polymerisierbare Verbindung mit mindestens zwei äthylenisch ungesättigten polymerisierbaren Gruppen und einen Photoinitiator in ausreichender Menge enthält, um die photoinitiierte radikalische Additionspolymerisation der polymerisierbaren Verbindung einzuleiten, dadurch gekennzeichnet, daß es zusätzlich eine Disulfidverbindung der Formel

$$R_1—CH_2—S—S—CH_2—R_2$$

enthält, worin

$R_1$ und $R_2$ gleich oder verschieden sind und Alkyl-, Cycloalkyl-, Aryl-, Aralkyl- oder N-substituierte Carbamoyl- oder Carbamoylalkylreste bedeuten.

2. Photopolymerisierbares Gemisch nach Anspruch 1, dadurch gekennzeichnet, daß es die Disulfidverbindung in einer Menge von 0,1 bis 10 Gew.-%, bezogen auf die nichtflüchtigen Bestandteile, enthält.

3. Photopolymerisierbares Gemisch nach Anspruch 1, dadurch gekennzeichnet, daß es als Photoinitiator eine Acridin-, Phenazin-, Chinoxalin, Chinazolin- oder Benzalchinaldinverbindung enthält.

4. Photopolymerisierbares Gemisch nach Anspruch 1, dadurch gekennzeichnet, daß es ein in verdünnten wäßrig-alkalischen Lösungen lösliches Bindemittel enthält.

5. Photopolymerisierbares Gemisch nach Anspruch 1, dadurch gekennzeichnet, daß es als polymerisierbare Verbindung einen Acryl- oder Methacrylsäureester eines mehrwertigen Alkohols mit einem Molekulargewicht unterhalb 1000 enthält.

6. Photopolymerisierbares Kopiermaterial mit einem Schichtträger und einer photopolymerisierbaren Schicht, die ein gesättigtes polymeres Bindemittel, eine radikalisch polymerisierbare Verbindung mit mindestens zwei äthylenisch ungesättigten polymerisierbaren Gruppen und einen Photoinitiator in ausreichender Menge enthält, um die photoinitiierte radikalische Additionspolymerisation der polymerisierbaren Verbindung einzuleiten, dadurch gekennzeichnet, daß es zusätzlich eine Disulfidverbindung der Formel

$$R_1—CH_2—S—S—CH_2—R_2$$

enthält, worin

$R_1$ und $R_2$ gleich oder verschieden sind und Alkyl-, Cycloalkyl-, Aryl-, Aralkyl- oder N-substituierte Carbamoyl- oder Carbamoylalkylreste bedeuten.

**Revendications**

1. Mélange photopolymérisable, qui contient un liant polymère saturé, un composé polymérisable par un mécanisme radicalaire comportant au moins deux groupes polymérisables à insaturation éthylénique et un photoinitiateur en quantité suffisante pour induire la polymérisation par addition radicalaire photoinitiée du composé polymérisable, caractérisé en ce qu'il contient en outre un composé qui est un disulfure de formule:

$$R_1—CH_2—S—S—CH_2—R_2$$

dans laquelle:

$R_1$ et $R_2$ sont identiques ou différents et désignent des radicaux alkyle, cycloalkyle, aryle, aralkyle ou carbamoyle N-substitué ou carbamoylalkyl N-substitué.

2. Mélange photopolymérisable selon la revendication 1, caractérisé en ce qu'il contient le disulfure en quantité de 0,1 à 10% en poids, par rapport aux constituants non volatils.

3. Mélange photopolymérisable selon la revendication 1, caractérisé en ce qu'il contient comme photoinitiateur un composé d'acridine, de phénazine, de quinoxaline, de quinazoline ou de benzylidéne-quinaldine.

4. Mélange photopolymérisable selon la revendication 1, caractérisé en ce qu'il contient un liant soluble dans les solutions alcalines aqueuses diluées.

5. Mélange photopolymérisable selon la revendication 1, caractérisé en ce qu'il contient comme composé polymérisable un ester acrylique ou méthacrylique d'un polyalcool ayant un poids moléculaire inférieur à 1000.

6. Matériau de reprographie photopolymérisable comportant un support et une couche photopolymérisable, qui contient un liant polmère saturé, un composé polymérisable par un mécanisme radicalaire possédant au moins deux groupes polymérisables à insaturation éthylénique et un photoinitiateur en quantité suffisante pour induire la polymérisation par addition radicalaire photoinitiée du composé polymérisable, caractérisé en ce qu'il contient en outre un composé qui est un disulfure de formule:

$$R_1—CH_2—S—S—CH_2—R_2$$

dans laquelle:

$R_1$ et $R_2$ sont identiques ou différents et désignent des radicaux alkyle, cycloalkyle, aryle, aralkyle ou carbamoyle N-substitué ou carbamoylalkyle N-substitué.

**Claims**

1. A photopolymerizable mixture which contains a saturated polymeric binder, a compound which is polymerizable by a free radical mechanism and has at least two ethylenically unsaturated polymerizable groups, and an adequate quantity of a photoinitiator for initiating the photoinitiated free-radical addition polymerization of the polymerizable compound, characterized in that it comprises additionally a disulfide compound of the formula

$$R_1—CH_2—S—S—CH_2—R_2$$

in which $R_1$ and $R_2$ are identical or different and represent alkyl, cycloalkyl, aryl, aralkyl or N-substituted carbamoyl or carbamoylalkyl radicals.

2. A photopolymerizable mixture as claimed in claim 1, which contains the disulfide compound in a quantity of 0.1 to 10% by weight, relative to the non-volatile constituents.

3. A photopolymerizable mixture as claimed in claim 1, which contains an acridine, phenazine, quinoxaline, quinazoline or benzalquinaldine compound as the photoinitiator.

4. A photopolymerizable mixture as claimed in claim 1, which contains a binder which is soluble in dilute aqueous-alkaline solutions.

5. A photopolymerizable mixture as claimed in claim 1, which contains an acrylic or methacrylic acid ester of a polyhydric alcohol, of a molecular weight of less than 1,000, as the photopolymerizable compound.

6. A photopolymerizable reproduction material with a layer support and a photopolymerizable layer which contains a saturated polymeric binder, a compound which is polymerizable by a free radical mechanism and has at least two ethylenically unsaturated polymerizable groups, and an adequate quantity of a photoinitiator for initiating the photoinitiated free-radical addition polymerization of the polymerizable compound, characterized in that it comprises additionally a disulfide compound of the formula

$$R_1—CH_2—S—S—CH_2—R_2$$

in which $R_1$ and $R_2$ are identical or different and represent alkyl, cycloalkyl, aryl, aralkyl or N-substituted carbamoyl or carbamoylalkyl radicals.